(19) Europäisches Patentamt / European Patent Office / Office européen des brevets

(11) **EP 2 660 973 B1**

(12) **EUROPEAN PATENT SPECIFICATION**

(45) Date of publication and mention of the grant of the patent:
**31.12.2014 Bulletin 2015/01**

(51) Int Cl.:
*H03F 1/02* *(2006.01)*      *H03F 3/195* *(2006.01)*
*H03F 3/24* *(2006.01)*      *H03F 3/68* *(2006.01)*

(21) Application number: **13156946.9**

(22) Date of filing: **27.02.2013**

(54) **Doherty amplifier**

Doherty-Verstärker

Amplificateur de Doherty

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **02.05.2012 JP 2012105217**

(43) Date of publication of application:
**06.11.2013 Bulletin 2013/45**

(73) Proprietor: **Kabushiki Kaisha Toshiba
Tokyo 105-8001 (JP)**

(72) Inventor: **Tamura, Koichi
Minato-ku, Tokyo 105-8001 (JP)**

(74) Representative: **Granleese, Rhian Jane
Marks & Clerk LLP
90 Long Acre
London WC2E 9RA (GB)**

(56) References cited:
**EP-A2- 0 899 875**

• **MEHDI SARKESHI ET AL: "A novel Doherty
amplifier for enhanced load modulation and
higher bandwidth", MICROWAVE SYMPOSIUM
DIGEST, 2008 IEEE MTT-S INTERNATIONAL,
IEEE, PISCATAWAY, NJ, USA, 15 June 2008
(2008-06-15), pages 763-766, XP031343110, ISBN:
978-1-4244-1780-3**

**Description**

FIELD

An embodiment relates to a Doherty amplifier.

BACKGROUND

A Doherty amplifier is known as an amplifier which amplifies microwave electric power. The Doherty amplifier has high electric power efficiency and high linearity. The Doherty amplifier includes a carrier amplifier which is biased to Class A to Class AB or Class B, and a peak amplifier which is biased to Class C.

In the Doherty amplifier, an inputted high-frequency signal is branched into two, one of branched signals is inputted into the carrier amplifier, and the other of branched signals is inputted into the peak amplifier through a quarter-wave transmission line. An amplified signal from the carrier amplifier is outputted through another quarter-wave transmission line. The Doherty amplifier combines the output signal from another quarter-wave transmission line, and the amplified signal from the peak amplifier, and outputs a combined signal.

Since a distributed line having a quarter-wave line length is used as the quarter-wave transmission line, the Doherty amplifier becomes large in size.

A Doherty amplifier having increased bandwidth and enhanced load modulation is proposed in "A Novel Doherty Amplifier for Enhanced Load Modulation and Higher Bandwidth", by M. Sarkeshi et al (Microwave Symposium Digest, 2008 IEEE MTT-S International, IEEE, Piscataway, NJ, USA, pp. 763-766). A varactor-based impedance transformer has been employed to replace the bulky and narrowband quarter-wave impedance inverter. Load modulation is carried out adaptively using the proposed varactor-based structure based on the input power level. An envelope detector is employed for adaptive impedance transformation of the carrier amplifier as well as bias adaptation of the peak amplifier. However, this prior art Doherty amplifier is complex in structure and has its limitations in terms of bandwidth of the employed all-pas filters.

Fig. 1 shows a block diagram of a Doherty amplifier concerning a first embodiment;
Fig. 2A shows an example of an element constant of a first filter circuit used for the Doherty amplifier concerning the first embodiment;
Fig. 2B shows the amplitude characteristic of the first filter circuit;
Fig. 2C shows the all-path filtering property of the first filter circuit;
Fig. 3A and Fig. 3B are drawings for explaining operation of the Doherty amplifier concerning the first embodiment, respectively;
Fig. 4 shows a block diagram of a Doherty amplifier of a prior art;

Fig. 5A shows a block diagram of a Doherty amplifier concerning a first modification of the first embodiment that is an example useful for understanding the present invention;
Fig. 5B shows a block diagram of a Doherty amplifier concerning a second modification of the first embodiment that is an example useful for understanding the present invention;
Fig. 6A shows a block diagram of a Doherty amplifier concerning a second embodiment;
Fig. 6B shows an example of element constants of the first filter circuit used for the Doherty amplifier concerning the second embodiment;
Fig. 7A shows a block diagram of a Doherty amplifier concerning a first modification of the second embodiment that is an example useful for understanding the present invention;
Fig. 7B shows a block diagram of a Doherty amplifier concerning a second modification of the second embodiment that is an example useful for understanding the present invention;
Fig. 8 shows a block diagram of a Doherty amplifier concerning a third embodiment; and
Fig. 9 shows a block diagram of a Doherty amplifier concerning a modification of the third embodiment.

DETAILED EMBODIMENT

According to one embodiment, there is provided a Doherty amplifier as recited in claim 1.

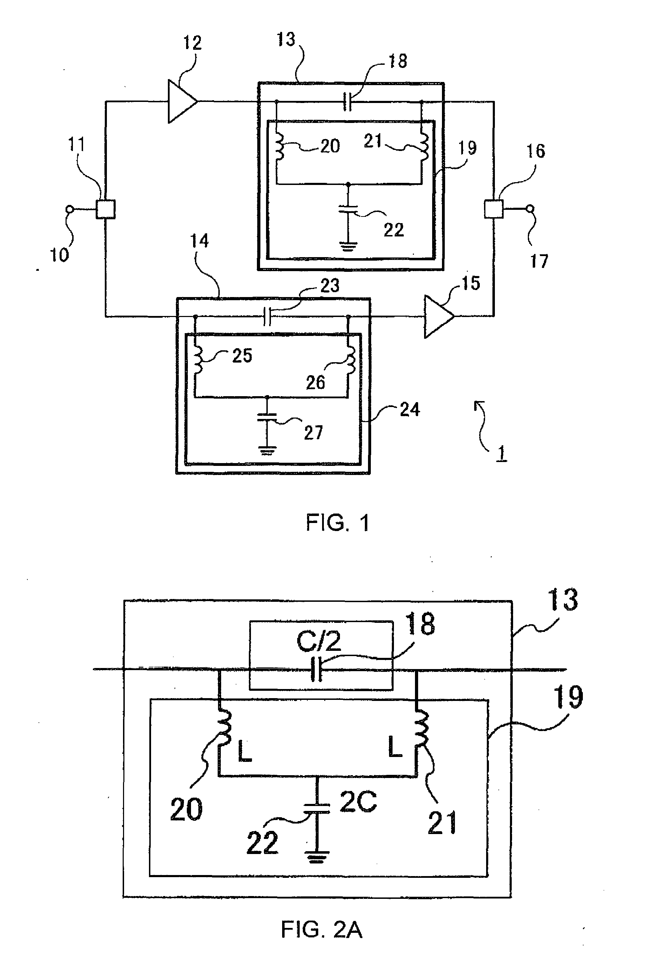

Hereafter, the Doherty amplifiers concerning the embodiments will be explained, referring to Fig. 1 through Fig. 9. A duplicated explanation will be omitted while attaching the same numeral to the same part in each drawing.

(First embodiment)

Fig. 1 is a block diagram of a Doherty amplifier concerning the first embodiment. A Doherty amplifier 1 is provided with: an input terminal 10; a distributor 11 which branches a microwave signal inputted from the input terminal 10; a carrier amplifier 12 which amplifies one output signal from the distributor 11; and a first filter circuit 13 which is provided in an output side of the carrier amplifier 12, and through which all-frequency-range component of an amplified signal from the carrier amplifier 12 passes and which shifts a phase of the amplified signal 90 degrees.

Further the Doherty amplifier 1 is provided with: a second filter circuit 14 through which all-frequency-range component of another output signal from the distributor 11 passes and which shifts a phase of the output signal 90 degrees; and a peak amplifier 15 which amplifies an output signal from the second filter circuit 14. Furthermore, the Doherty amplifier 1 is provided with: a combiner 16 which combines an amplified signal from the peak amplifier 15 and an output signal from the first filter circuit 13; and an output terminal 17 connected to the combiner 16. The first filter circuit 13 and the second filter circuit 14 are formed of a plurality of lumped-parameter elements, respectively.

A microwave signal which has a carrier frequency within a microwave band is inputted into the input terminal 10. The distributor 11 distributes an electric power of an input signal into two lines. The distributor 11 uses a 90-degree hybrid circuit with two input terminals and two output terminals, for example. The microwave signal is inputted into one of the input terminals, and a terminating resistor is connected to the other of the input terminals. The distributor 11 outputs a signal with equal amplitude from each output terminal.

The carrier amplifier 12 includes an amplifying element and a bias circuit which sets an operating point of this amplifying element as Class A, Class AB or Class B. The amplifying element is an FET (Field Effect Transistor), for example.

The first filter circuit 13 is provided with an HPF (High Pass Filter) 18 through which a higher-frequency-range component of the amplified signal passes, and an LPF (Low Pass Filter) 19 which is connected in parallel with the HPF 18 and through which a lower-frequency-range component of the amplified signal passes. The HPF 18 is one capacitor. Hereinafter, the HPF 18 may be written as a capacitor 18. The LPF 19 includes: an inductor 20 of which one terminal is connected to one terminal of the capacitor 18; another inductor 21 of which one terminal is connected to another terminal of the inductor 20, and of which another terminal is connected to another terminal of the capacitor 18; and another capacitor 22 of which one terminal is connected to a connecting point between the inductors 20 and 21, and of which another terminal is connected to a grounding conductor. Chip components to be mounted on a dielectric substrate are used for the capacitor 18, the inductor 20, the inductor 21 and the capacitor 22. The inductors 20, the inductor 21 and the capacitor 22 form T type connection structure.

Element constant of each of the capacitor 18, the inductor 20, the inductor 21 and the capacitor 22 is decided based on characteristic impedance, an amount of phase shift of 90 degrees and an operating frequency of the input signal to be inputted into the Doherty amplifier 1. The characteristic impedance means impedance in the case that this carrier amplifier 12 is seen from an output side of the carrier amplifier 12. A 90-degree phase shift is that giving a 90-degree passage phase difference, that is, an amount of phase shift, to a signal, and it means that an output signal of signal phase

$(\varphi-90)$ which is delayed at a 90-degree phase against a signal phase $(\varphi)$ of an input signal is outputted. When a signal phase is changed 180 degrees without a loss on a phase characteristic curve of the first filter circuit 13 at a frequency Fo, a frequency Fa which is a half of the frequency Fo is called an operation frequency.

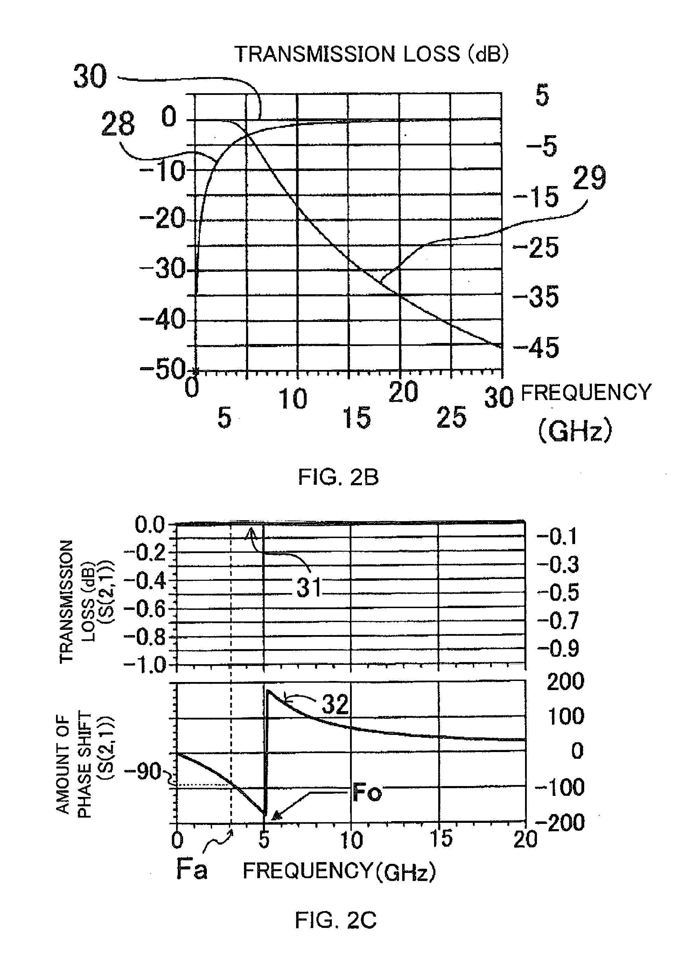

Fig. 2A shows an example of element constants of components of the first filter circuit 13. Fig. 2B shows the combined amplitude characteristic obtained by a parallel connection of the HPF 18 and the LPF 19 in Fig. 2A. The first filter circuit 13 has the HPF 18 inserted in series in a signal path, and the LPF 19 connected in parallel with the HPF 18. In the LPF 19, the inductor 20, the inductor 21 and the capacitor 22 are connected to T type. The capacitor 18 (the HPF 18) has capacitance C/2 as an element constant. The inductors 20 and 21 have inductance L as an element constant, respectively, and the capacitor 22 has capacitance 2C. Each of such C and L has a value which fills a relation of formula (I) and formula (II).

$$Fo = 1/\{(2\pi) \sqrt{(LC)}\} \quad ... (I)$$

$$Zo = \sqrt{(L/C)} \quad ... (II)$$

Here, the frequency Fo is a frequency that a signal phase on a phase characteristic curve changes 180 degrees. When a signal has a carrier frequency Fo, this signal receives the amount of phase shift of 180 degrees by the first filter circuit 13. The characteristic impedance Zo expresses characteristic a impedance of a transmission line in the case that this carrier amplifier 12 is seen from an output side of the carrier amplifier 12.
A sign $\sqrt{}$ expresses an operation of a square root.

Fig. 2B shows an amplitude characteristic 28 which shows a frequency characteristic of only the HPF 18, an amplitude characteristic 29 which shows a frequency characteristic of only the LPF 19, and an amplitude characteristic 30 which shows a frequency characteristic when the HPF 18 and the LPF 19 are connected in parallel. An amplitude characteristic means a frequency characteristic of a voltage ratio of an output signal to a reference signal inputted. The amplitude characteristic 30 is a ratio of a voltage of a microwave signal which passed through the first filter circuit 13 to a voltage of a microwave signal which is inputted into the first filter circuit 13. The attenuation is indicated by dB. By connecting in parallel the HPF 18 which has the amplitude characteristic 28 and the LPF 19 which has the amplitude characteristic 29, the first filter circuit 13 realizes the amplitude characteristic 30 in which an amplitude is flat over a 0-30 GHz range. As shown in Fig. 2A, when the first filter circuit 13 uses a filter constant of a filter called an all-path filter, the first filter circuit 13 can be structured by lumped-parameter elements.

Fig. 2C is a drawing for explaining the all-path filtering property of the first filter circuit 13 of Fig. 2A. Symbols as stated above express the same elements as the elements of those symbols. S (2, 1) corresponds to the loss property S21 of S parameter. The amplitude characteristic 31 is shown in an upper half of Fig. 2C, and an phase characteristic curve 32 is shown in a lower half of Fig. 2C. The Doherty amplifier 1 outputs a signal of a microwave band region with passage loss of 0 dB as shown by the amplitude characteristic 31. In addition, as shown by the phase characteristic curve 32, the amount of phase shift at the frequency Fo is 180 degrees, and the amount of phase shift at the frequency Fa is 90 degrees in the same phase. The C, L and Fa fill formula (III) and formula (IV).

$$Fa = 1/\{2 \times (2\pi) \sqrt{(LC)}\} \quad ... \text{ (III)}$$

$$Za = \sqrt{(L/C)} \quad ... \text{ (IV)}$$

The frequency Fa is an operating frequency which has a value of a half of the phase shift amount of the frequency Fo on the phase characteristic curve 32. The characteristic impedance Za is equal to the characteristic impedance Zo. When a frequency of a microwave signal inputted into the Doherty amplifier 1 is the operating frequency Fa, this microwave signal receives a phase shift of 90 degrees by the first filter circuit 13.
A sign x expresses a multiplication. A sign √ expresses an operation of a square root.
In addition, the second filter circuit 14 of Fig. 1 is provided with a HPF (High Pass Filter) 23 through which a higher-frequency-range component of another output signal distributed by the distributor 11 passes, and a LPF (Low Pass Filter) 24 which is connected in parallel with the HPF 23 and through which a lower-frequency-range component of this another output signal passes. The HPF 23 comprises one capacitor. Hereafter, the HPF 23 may be written as the capacitor 23. The LPF 24 includes: an inductor 25 of which one terminal is connected to one terminal of the capacitor 23; another inductor 26 of which one terminal is connected to another terminal of the inductor 25, and of which another terminal is connected to another terminal of the capacitor 23; and a capacitor 27 of which one terminal is connected to a connecting point between the inductors 25 and 26, and of which another terminal is connected to the grounding conductor. Chip components to be mounted on the dielectric substrate are used for the capacitor 23, the inductor 25, the inductor 26 and the capacitor 27. These inductors 25, the inductor 26 and the capacitor 27 form T type connection structure. Each element constant of the capacitors 23 and the inductor 25, etc. is decided like each element constant of the first filter circuit 13. In addition, the second filter circuit 14 is an all-path filter, and has an amplitude characteristic equivalent to a combined amplitude characteristic obtained by connecting the LPF 23 and the HPF2 4 in parallel. An amplitude characteristic of the second filter circuit 14 is substantially the same as the amplitude characteristic 31. A phase characteristic of the second filter circuit 14 is also substantially the same as the phase characteristic curve 32.
The peak amplifier 15 has an amplifying element and a bias circuit which sets an operating point of this amplifying element as Class B or Class C. The amplifying element is an FET which is different from the FET for the carrier amplifier 12. The FET of the carrier amplifier 12 and the FET of the peak amplifier 15 may share a grounding terminal.
The combiner 16 combines signals of the same frequency band of the amplified signal from the peak amplifier 15 and an output signal from the first filter circuit 13, and outputs a combined signal. A pair of parallel lines on a dielectric substrate is used for the combiner 16, for example.
In the Doherty amplifier 1 which has such composition, when there is no signal input, a bias of Class AB or Class B is given to the FET of the carrier amplifier 12, and a bias of Class C is given to the FET of the peak amplifier 15.

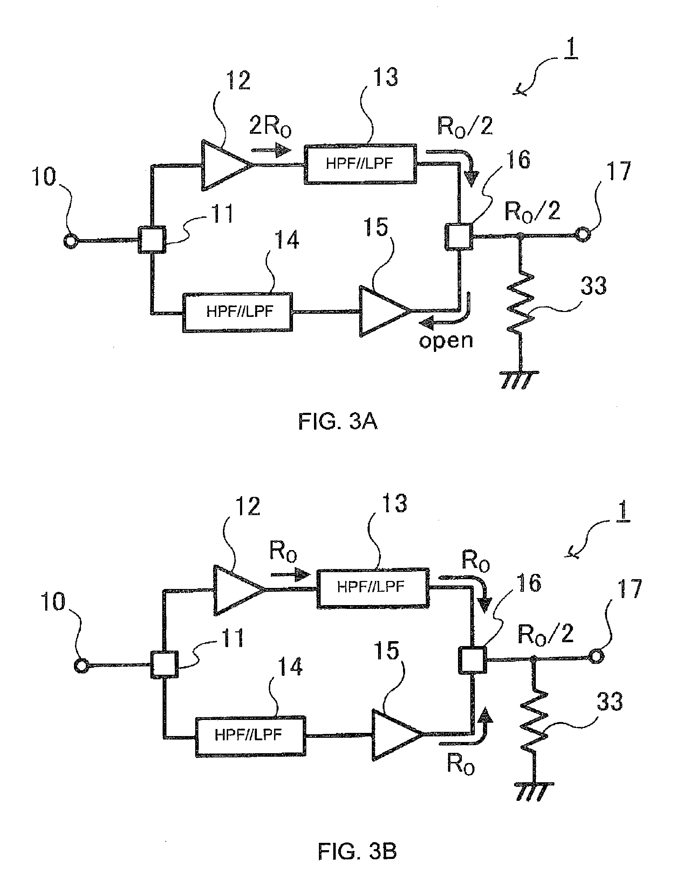

Fig. 3A is a drawing for explaining operation of the Doherty amplifier 1 when input power is small. Fig. 3B is a drawing for explaining operation of the Doherty amplifier 1 when the input power is large. Small electric power means a case where the FET of the carrier amplifier 12 is within a range where the linearity of input/output on the amplification characteristic can be maintained. Large electric power means a case where the FET of the carrier amplifier 12 is out of the range where the linearity of input/output on the amplification characteristic can be maintained. Symbols as stated above express the same elements as the elements of those symbols. A microwave signal is inputted into the Doherty amplifier 1 through an impedance matching circuit which is not illustrated.
When instantaneous input power is small, as shown in Fig. 3A, the peak amplifier 15 of which the amplifying element is biased to Class C is in an OFF state, and an output impedance of the peak amplifier 15 is in an opening state. The Doherty amplifier 1 performs amplification operation only with the carrier amplifier 12. The Doherty amplifier 1 supplies only the output signal by the carrier amplifier 12 to a load 33. A load 33 shall be connected between the output terminal 17 and the grounding conductor, and shall have load impedance R0/2. It is assumed that a characteristic impedance of the first filter circuit 13 is set as R0.
When it is assumed that the first filter circuit 13 is a lossless line, a voltage V0 and a current 10 at an input terminal of the first filter circuit 13, and a voltage VL and a current IL at an output terminal of the first filter circuit 13 are expressed by VL=jR0 I0 and IL=(j/R0) V0 from a circuit equation. Since a load impedance VUIL seen from the output terminal of the first filter circuit 13 is R0/2, a following formula will be obtained when these VL and IL are inputted.

$$R0/2 = VL/IL = (R0) \times (Ro) \times (I0/V0)$$

V0/I0=2R0 is obtained by modification of this formula.

V0=2R010 is obtained. This shows that the load impedance seen from the input terminal of the first filter circuit 13 becomes 2R0. This result shows that the impedance value of the load 33 which is seen from an output side of the carrier amplifier 12 is changed to 2R0 from R0/2. This high load impedance increases the efficiency when the small electric power is amplified, in the case that a power supply voltage is constant. When the load impedance is 2R0, although saturation electric power of the carrier amplifier 12 is small, the efficiency is high. A power consumption of the carrier amplifier 12 can be suppressed and the Doherty amplifier 1 operates in high electric power efficiency.

By changing the operating point of the amplifying element on the amplification characteristic to a change of instantaneous input power, the carrier amplifier 12 follows the change of instantaneous input power. By shifting the operating point of the amplifying element of the carrier amplifier 12 to a saturation region side, the Doherty amplifier 1 amplifies a microwave signal with the instantaneous input power enlarged a little with the carrier amplifier 12. By an input of electric power with a larger level, the operation of the carrier amplifier 12 will be saturated and will be in a state where the amplification linearity is broken. The peak amplifier 15 operates so as to compensate a deficient electric power in amplification by the carrier amplifier 12.

When the instantaneous input power is large, as shown in Fig. 3B, the peak amplifier 15 will be in an ON state, and the Doherty amplifier 1 supplies an output signal from the peak amplifier 15 to the load 33, and an amplified signal by the carrier amplifier 12 and an amplified signal by the peak amplifier 15 are combined. The load impedance VL/IL of the output terminal of the first filter circuit 13 is R0, and a load impedance of an output terminal of the peak amplifier 15 is also R0. A following formula will be obtained when VL and IL are inputted to a circuit equation of a lossless line.

$$R0 = VL/IL = (R0) \times (R0) \times (I0/V0)$$

V0/I0=R0 is obtained by modification of this formula, and V0=R0 10 is obtained. This shows that the load impedance seen from the input terminal of the first filter circuit 13 becomes R0. As a result, an impedance conversion by the first filter circuit 13 is not performed, and the load impedance seen from the output side of the carrier amplifier 12 also becomes R0. When the load impedance is R0, as for both the carrier amplifier 12 and the peak amplifier 15, bias of each amplifying element is set so that saturation electric power may become large. For this reason, the Doherty amplifier 1 obtains a saturation electric power of a bigger level than a saturation electric power level at the time of the instantaneous input power. Since a bias of each amplifying element is set up near the operating point that an amplifying element outputs the saturation electric power, the high electric power efficiency is obtained by the Doherty amplifier 1.

When an electric power level of the microwave signal from the input terminal 10 increases further, the peak amplifier 15 also begins to be saturated, but the carrier amplifier 12 and the peak amplifier 15 have been saturated. Also at this time, the efficiencies of the carrier amplifier 12 and the peak amplifier 15 are good.

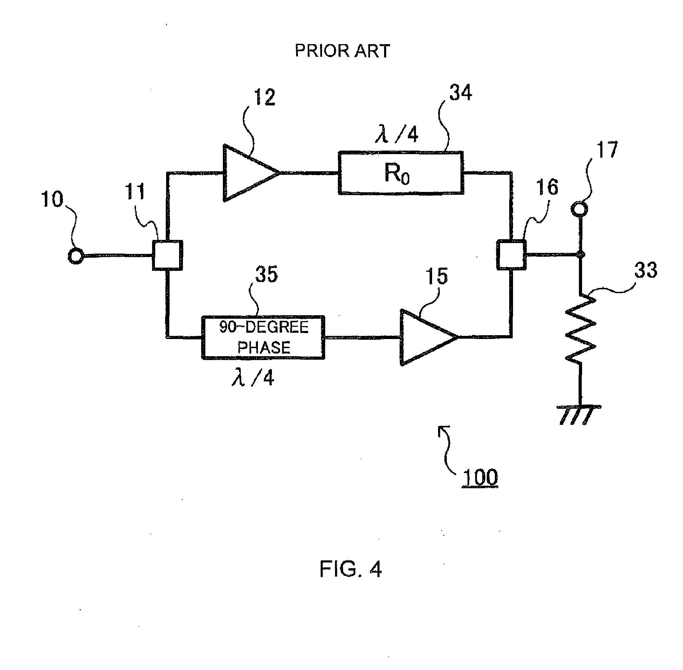

Fig. 4 is a block diagram of a Doherty amplifier by a prior art. Symbols as stated above express the same elements as elements of the symbols, or express equivalent elements. A Doherty amplifier 100 is provided with a first transmission line 34 having an electric length of quarter-wavelength which is provided at an output side of a carrier amplifier 12, and a second transmission line 35 having an electric length of quarter-wavelength which is provided at an input side of the peak amplifier 15. Either of these transmission lines 34 and 35 is realized by a distributed line which requires a size longer than a quarter-wave line length, and generates a phase shift difference of 90 degrees.

However, in this example of Fig. 4, since the quarter-wave line is used, a size of the Doherty amplifier becomes large because of the line length. For example, the quarter-wavelength in free space is 75 mm at 1 GHz, and the quarter-wavelength is 7.5 mm at 10 GHz. In the Doherty amplifier by the prior art, even if a wavelength shortening rate is taken into a consideration, these values of 75 mm or 7.5 mm are a technical problem for realizing a miniaturization of the Doherty amplifier. The wavelength shortening rate means a ratio to the velocity of light of a propagation velocity of an electromagnetic wave energy on a microstrip line, and it takes a value which is larger than 0 and smaller than 1. Generally, one wavelength of electromagnetic waves in a dielectric substrate is shortened, and it becomes shorter than one wavelength of electromagnetic waves in free space. Even if it is a quarter-wave line shortened, the quarter-wave line enlarges the size of the Doherty amplifier. In realizing the Doherty amplifier using these transmission lines 34 and 35 by MMIC (Monolithic Microwave Integrated Circuit), a technical problem that a chip size is large exists.

On the other hand, according to the Doherty amplifier 1, since a 90-degree phase shifter formed by the quarter-wave transmission line of the prior art is realized by using the first filter circuit 13 and the second filter circuit 14 which are all-path filters, the 90-degree phase shifter can be constituted by the lumped-parameter elements. The Doherty amplifier can be made small in size by using a filter circuit which is formed by lumped-parameter elements and has all-frequency-range passage characteristic instead of the quarter-wave transmission lines 34 and 35. In addition, the filter circuit is realizable by the MMIC. Therefore, the Doherty amplifier can be made small in size. In addition, since a passage loss of the first filter circuit 13 and the second filter circuit 14 which are all-path filter circuit is 0 dB, a decreased part of a whole gain of the Doherty amplifier 1 can be reduced.

(Modification of first embodiment)

In the Doherty amplifier concerning an example useful for understanding the present invention, an all-path filter may be provided in one of two lines.

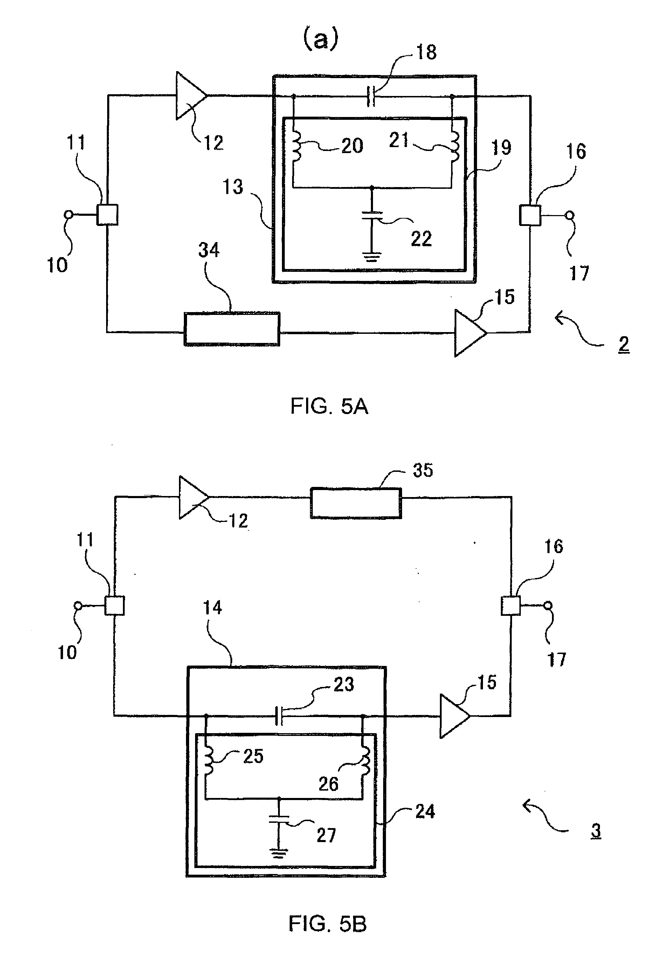

Fig. 5A shows a block diagram of a Doherty amplifier concerning a first modification of the first embodiment that is an example useful for understanding the present invention. Symbols as stated above express the same elements as the elements of those symbols. The Doherty amplifier 2 has a first filter circuit 13 behind a carrier amplifier 12, and has a transmission line 34 in front of a peak amplifier 15. An all-frequency-range component of an amplified signal from the carrier amplifier 12 passes through the first filter circuit 13, and the first filter circuit 13 shifts a phase of the amplified signal 90 degrees. The transmission line 34 shifts a phase of a signal inputted 90 degrees. The first filter circuit 13 is an all-path filter circuit constituted by lumped-parameter elements, and the transmission line 34 is a quarter-wave distributed line.

Fig. 5B shows a block diagram of a Doherty amplifier concerning a second modification of the first embodiment that is an example useful for understanding the present invention. Symbols as stated above express the same elements as the elements of those symbols. The Doherty amplifier 3 has a transmission line 35 behind a carrier amplifier 12, and has a second filter circuit 14 in front of a peak amplifier 15. An all-frequency-range component of a signal inputted passes through the second filter circuit 14, and the second filter circuit 14 shifts a phase of the signal inputted 90 degrees. The transmission line 35 shifts a phase of an amplified signal from the carrier amplifier 12 90 degrees. The second filter circuit 14 is an all-path filter circuit constituted by lumped-parameter elements, and the transmission line 35 is a quarter-wave distributed line.

According to this modification, since one of two quarter-wave transmission lines is replaced by a filter circuit constituted by lumped-parameter elements, the Doherty amplifier can be made small in size. In addition, since an all-path filter is used as a filter circuit, a decreased part of a whole gain of the Doherty amplifier 2, 3 can be reduced.

(Second embodiment)

As components of the above-mentioned first filter circuit 13 and the second filter circuit 14, other lumped-parameter elements may be used.

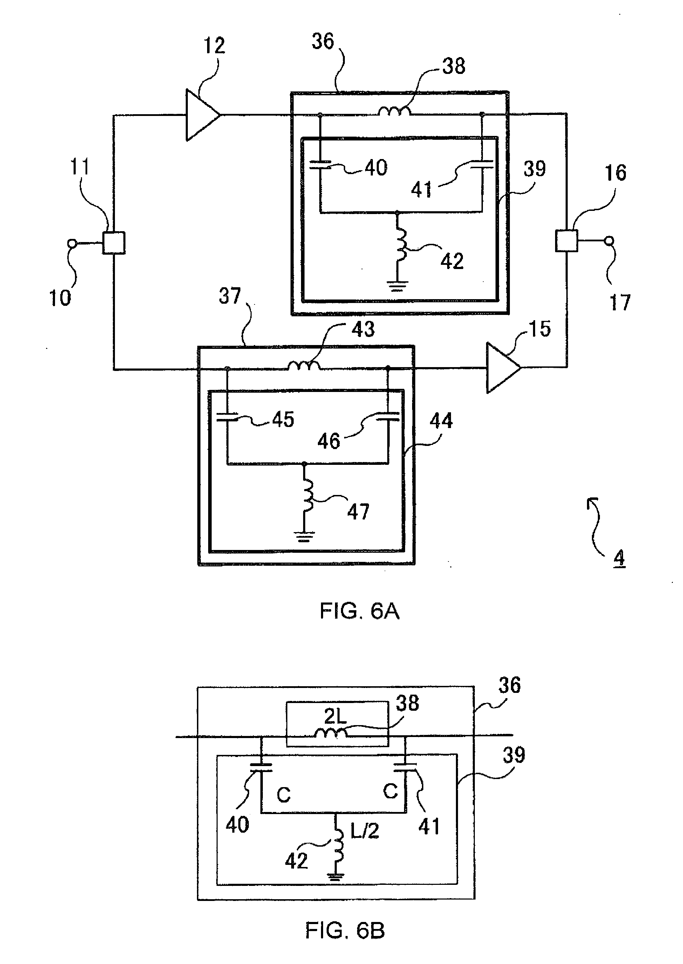

Fig. 6A shows a block diagram of a Doherty amplifier concerning the second embodiment. Symbols as stated above express the same elements as the elements of those symbols. A Doherty amplifier 4 is provided with: a first filter circuit 36 through which an all-frequency-range component of an amplified signal from the carrier amplifier 12 passes, and which shifts a phase of this amplified signal 90 degrees; and a second filter circuit 37 through which an all-frequency-range component of another output signal from the distributor 11 passes, and which shifts a phase of this output signal 90 degrees. The first filter circuit 36 and the second filter circuit 37 are formed of a plurality of lumped-parameter elements, respectively.

The first filter circuit 36 is provided with a LPF 38 (it may be written as the inductor 38 below), and a HPF 39 which is connected in parallel with this LPF 38. A lower-frequency-range of an amplified signal passes through the LPF 38, and a higher-frequency-range of the amplified signal passes through the HPF 39. The HPF 39 includes: a capacitor 40 of which one terminal is connected to one terminal of the inductor 38; another capacitor 41 of which one terminal is connected to another terminal of this capacitor 40, and of which another terminal is connected to another terminal of the inductor 38; and another inductor 42 of which one terminal is connected to a connecting point between these capacitors 40 and 41, and of which another terminal is connected to a grounding conductor. Chip components on a dielectric substrate are used for the inductor 38, the capacitor 40, the capacitor 41, and the inductor 42. These capacitors 40, the capacitor 41, and the inductor 42 form T type connection structure. Each element constant of these inductor 38 etc. is decided like the example of each element constant of the first filter circuit 13 of the above-mentioned first embodiment.

Fig. 6B is a drawing showing an example of each element constant of components of the LPF 38, and components of the HPF 39. Symbols as stated above express the same elements as the elements of those signals. The inductor 38 has inductance 2L as an element constant. The capacitors 40 and 41 have capacitance C as an element constant, respectively, and the inductor 42 has inductance L/2. Each of such C and L is calculated based on a relation of the above-mentioned formula (I) and (II) of the first embodiment, or substantially the same relational as this relation.

The first filter circuit 36 is an all-path filter, and has an amplitude characteristic equivalent to a combined amplitude characteristic obtained by connecting the LPF 38 and the HPF 39 in parallel. The amplitude characteristic of the first filter circuit 36 has a flat characteristic curve in a 0-30GHz frequency band like the amplitude characteristic 31 in the upper half of Fig. 2C. The phase characteristic of the first filter circuit 36 is substantially the same as the phase characteristic curve 32 in the lower half of Fig. 2C. The first filter circuit 36 gives an amount of phase shift of 90 degrees to a microwave signal of the carrier frequency Fa, and outputs a resultant signal.

On the other hand, the second filter circuit 37 of Fig. 6A is provided with an LPF 43 (inductor 43) and an HPF 44 which is connected in parallel with the LPF 43. A lower-frequency-range of another output signal outputted from a distributor 11 passes through the LPF 43, and a higher-frequency-range of the another output signal passes through the HPF 44. This HPF 44 includes: a capacitor 45 of which one terminal is connected to one terminal of the inductor 43; another capacitor 46 of which one terminal is connected to another terminal of this capacitor 45, and of which another terminal is connected to another terminal of the inductor 43; and an inductor 47 of which one terminal is connected to a connecting point between the capacitors 45 and 46, and another terminal is connected to the grounding conductor. These capacitors 45, the capacitor 46, and the inductor 47 form T type connection structure. Each element constant of the LPF 43 and the HPF 44 which constitute the second filter circuit 37 is decided as well as the example of each element constant of the first filter circuit 13 of the first embodiment. The second filter circuit 37 is an all-path filter, and has an amplitude characteristic equivalent to a combined amplitude characteristic obtained by connecting the LPF 43 and the HPF 44 in parallel. The amplitude characteristic of the second filter circuit 37 is substantially the same as the amplitude characteristic 31. The phase characteristic of the second filter circuit 37 is also substantially the same as the phase characteristic curve 32.

Like the Doherty amplifier 1 of the first embodiment, the Doherty amplifier 4 which has such composition operates in high electric power efficiency, when the instantaneous input power is small, and when the instantaneous input power is large.

According to the Doherty amplifier 4, since the first filter circuit 36 and the second filter circuit 37 which are all-path filters are used, each filter circuit can be constituted by lumped-parameter elements, and the Doherty amplifier 4 can be made small in size. In addition, a filter circuit is realizable by the MMIC. Since a passage loss of the first filter circuit 13 and the second filter circuit 14 which are all-path filter circuits is 0 dB, a decreased part of a whole gain of the Doherty amplifier 4 can be reduced.

(Modification of second embodiment)

In a Doherty amplifier concerning an example useful for understanding the present invention, an all-path filter may be provided in only one of two lines.

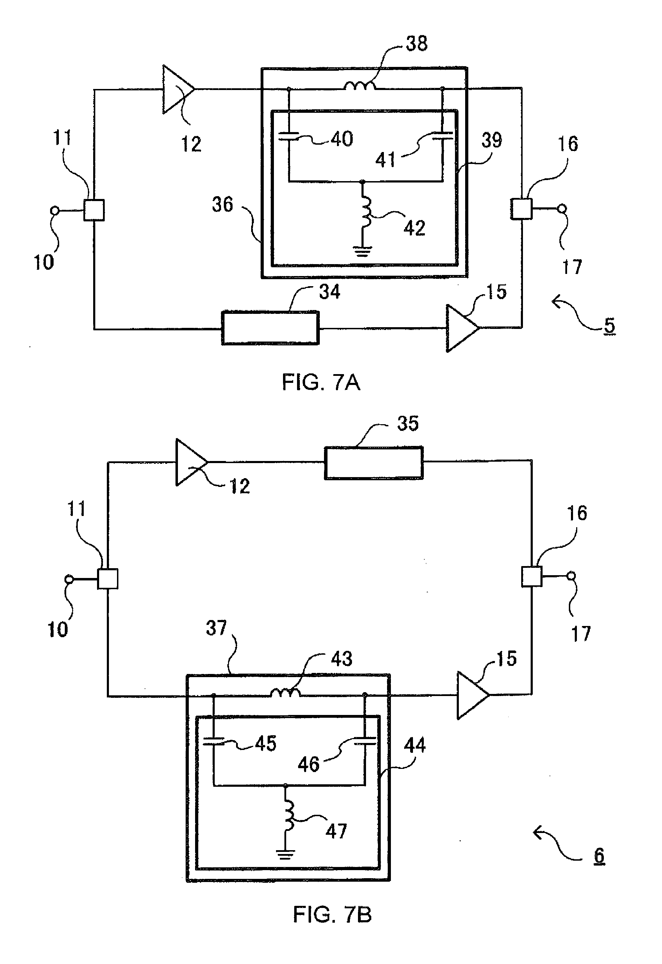

Fig. 7A shows a block diagram of a Doherty amplifier concerning a first modification of the second embodiment that is an example useful for understanding the present invention. The Doherty amplifier 5 has a first filter circuit 36 behind a carrier amplifier 12. Fig. 7B shows a block diagram of a Doherty amplifier concerning a second modification of the second embodiment that is an example useful for understanding the present invention. The Doherty amplifier 6 has a second filter circuit 37 in front of a peak amplifier 15. Symbols as stated above express the same elements as the elements of those symbols.

As shown in Fig. 7A, in a Doherty amplifier 5, an all-frequency-range component of an amplified signal from the carrier amplifier 12 passes through the first filter circuit 36, and the first filter circuit 36 shifts a phase of the signal 90 degrees. The transmission line 34 shifts a phase of a signal inputted 90 degrees.

As shown in Fig. 7B, in a Doherty amplifier 6, an all-frequency-range component of a signal passes through the second filter circuit 37, and the second filter circuit 37 shifts a phase of the signal 90 degrees. The transmission line 35 shifts a phase of an amplified signal from the carrier amplifier 12 90 degrees.

The Doherty amplifier 5 has the first filter circuit 36 constituted by lumped-parameter elements in only one line. The Doherty amplifier 6 also has the second filter circuit 37 constituted by lumped-parameter elements in only one line. When a quarter-wave transmission line is replaced by a filter circuit constituted by lumped-parameter elements, the Doherty amplifier can be made small in size. In addition, since an all-path filter is used as a filter circuit, a decreased part of a whole gain of the Doherty amplifier 5, 6 can be reduced.

(Third embodiment)

An all-path filter which has a composition of Fig. 2A, and an all-path filter which has a composition of Fig. 6B may be provided in two branched lines, respectively.

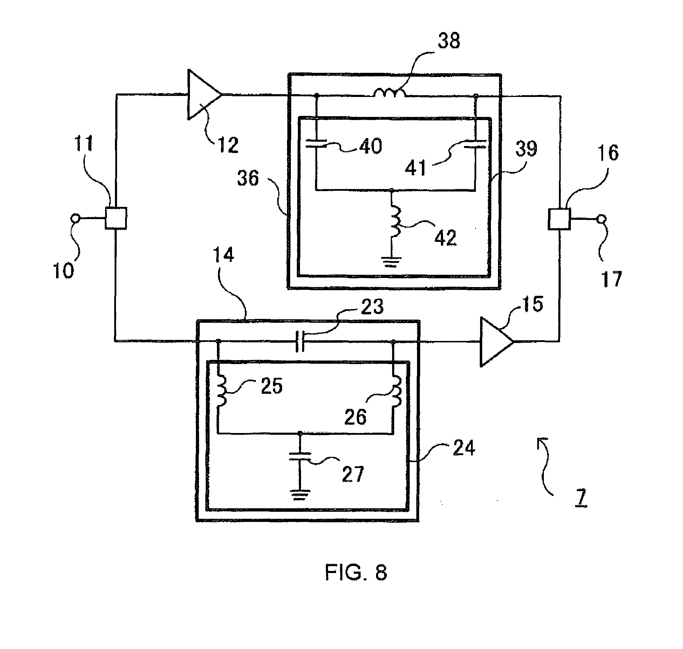

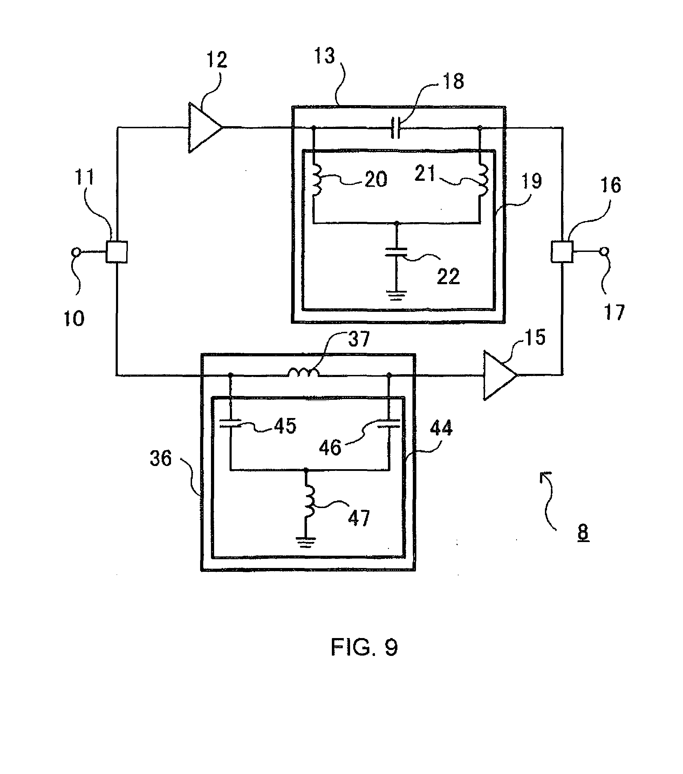

Fig. 8 shows a block diagram of a Doherty amplifier concerning a third embodiment. Fig. 9 shows a block diagram of a Doherty amplifier concerning a modification of the third embodiment. Symbols as stated above express the same elements as elements of those symbols.

The Doherty amplifier 7 of Fig. 8 and the Doherty amplifier 8 of Fig. 9 also perform substantially the same operation as the operation of the Doherty amplifier 1. By forming a filter circuit by lumped-parameter elements, the Doherty amplifier can be made small in size. In addition, since a passage loss is 0 dB by an all-path filter, the Doherty amplifiers 7 and 8 can reduce a decreased part of the whole gain.

(Others)

In the Doherty amplifier 1, internal matching networks may be connected to an input terminal and an output terminal of the amplifying element of the carrier amplifier 12, respectively. The internal matching networks adjust impedances of an input stage and an output stage of the FET. The internal matching networks are connected to an amplifying element of the peak amplifier 15. In addition, impedance conversion circuits may be connected to an output side of the distributor 11, and an input side of the combiner 16, respectively.

While certain embodiments have been described, these embodiments have been presented by way of example only, and are not intended to limit the scope of the invention as claimed. Indeed, the novel embodiments described herein may be embodied in a variety of other forms; furthermore, various omissions, substitutions and changes in the form of the embodiments described herein may be made without departing from the scope of the invention as claimed. The accompanying claims and their equivalents are intended to cover such forms or modifications as would fall within the scope of the invention as claimed.

## Claims

1. A Doherty amplifier (1), comprising:

   a distributor (11) which distributes a high-frequency signal inputted into two;
   a carrier amplifier (12) which amplifies one output signal from the distributor (11);
   a first filter circuit (13) which shifts a phase of an amplified signal from the carrier amplifier (12);
   a second filter circuit (14) which shifts a phase of the other output signal from the distributor (11);
   a peak amplifier (15) which amplifies an output signal from the second filter circuit (14); and
   a combiner (16) which combines an amplified signal from the peak amplifier (15) and an output signal from the first filter circuit (13);
   **characterized in that**
   the first filter circuit (13) includes a first high pass filter (18) which transmits a higher-frequency-range component of the amplified signal from the carrier amplifier (12), and a first low pass filter (19) which is connected in parallel with the first high pass filter (13), and which transmits a lower-frequency-range component of the amplified signal from the carrier amplifier (12),
   the first filter circuit (13) transmits an all-frequency-range component of the amplified signal from the carrier amplifier (12),
   the second filter circuit (14) includes a second high pass filter (23) which transmits a higher-frequency-range component of the other output signal from the distributor (11), and a second low pass filter (24) which is connected in parallel with the second high pass filter (23), and which transmits a lower-frequency-range component of the other output signal from the distributor (11), and
   the second filter circuit (14) transmits an all-frequency-range component of the other output signal from the distributor (11)
   wherein the first filter circuit (13) has a plurality of lumped-parameter elements of element constant determined by a characteristic impedance of an output side of the carrier amplifier (12), an amount of phase shift, and an operating frequency of the high-frequency signal and wherein the second filter circuit (14) has a plurality of lumped-parameter elements of element constant determined by a characteristic impedance of an input side of the peak amplifier (15), an amount of phase shift, and an operating frequency of the high-frequency signal.

2. The Doherty amplifier according to claim 1, wherein the first filter circuit shifts a phase of a signal of operation frequency inputted to the first filter circuit by 90 degrees and the second filter circuit shifts a phase of a signal of operation frequency inputted to the second filter circuit by 90 degrees.

## Patentansprüche

1. Doherty-Verstärker (1), Folgendes umfassend:

   einen Verteiler (11), der ein eingegebenes Hochfrequenzsignal in zwei verteilt;
   einen Trägerverstärker (12), der ein Ausgangssignal vom Verteiler (11) verstärkt;
   eine erste Filterschaltung (13), die eine Phase eines verstärkten Signals vom Trägerverstärker (12) verschiebt;
   eine zweite Filterschaltung (14), die eine Phase des anderen Ausgangssignals vom Verteiler (11) verschiebt;
   einen Spitzenverstärker (15), der ein Ausgangssignal von der zweiten Filterschaltung (14) verstärkt, und
   einen Kombinierer (16), der ein verstärktes Signal vom Spitzenverstärker (15) und ein Ausgangssignal von der ersten Filterschaltung (13) kombiniert;
   **dadurch gekennzeichnet, dass**
   die erste Filterschaltung (13) ein erstes Hochpassfilter (18) einschließt, das eine Komponente im höheren Frequenzbereich des verstärkten Signals vom Trägerverstärker (12) überträgt, und eine erstes Tiefpassfilter (19), das zum ersten Hochpassfilter (13) parallel geschaltet ist und das eine Komponente im niedrigeren Frequenzbereich des verstärkten Signals vom Trägerverstärker (12) überträgt;
   die erste Filterschaltung (13) eine Komponente im Bereich aller Frequenzen des verstärkten Signals vom Trägerverstärker (12) überträgt,
   die zweite Filterschaltung (14) ein zweites Hochpassfilter (23) einschließt, das eine Komponente im höheren Frequenzbereich des anderen Ausgangssignals vom Verteiler (11) überträgt, und ein zweites Tiefpassfilter (24), das mit dem zweiten Hochpassfilter (23) parallel geschaltet ist und eine Komponente im niedrigeren Frequenzbereich des anderen Ausgangssignals vom Verteiler (11) überträgt, und
   die zweite Filterschaltung (14) eine Komponente im Bereich aller Frequenzen des anderen Ausgangssignals vom Verteiler (11) überträgt, worin die erste Filterschaltung (13) eine Vielzahl von Elementen mit konzentrierten Parametern der Elementkonstante hat, bestimmt von einer charakteristischen Impedanz einer Ausgangsseite des Trägerverstärkers (12), einer Größe der Phasenverschiebung und einer Betriebsfrequenz des Hochfrequenzsignals, und worin die zweite Filterschaltung (14) eine Vielzahl von Elementen mit konzentrierten Parametern der Elementkonstante hat, bestimmt von einer charakteristischen Impedanz einer Eingangsseite des Spitzenverstärkers (15), einer Größe der Phasenverschiebung und einer Betriebsfrequenz des Hochfrequenzsignals.

**2.** Doherty-Verstärker nach Anspruch 1, worin die erste Filterschaltung eine Phase eines in die erste Filterschaltung eingegebenen Signals der Betriebsfrequenz um 90 Grad verschiebt und die zweite Filterschaltung eine Phase eines in die zweite Filterschaltung eingegebenen Signals der Betriebsfrequenz um 90 Grad verschiebt.

## Revendications

**1.** Amplificateur Doherty (1), comprenant :

un répartiteur (11) qui répartit sous forme de deux signaux un signal haute fréquence entré ;
un amplificateur de porteuse (12) qui amplifie un signal de sortie en provenance du répartiteur (11) ;
un premier circuit de filtrage (13) qui décale une phase d'un signal amplifié en provenance de l'amplificateur de porteuse (12) ;
un second circuit de filtrage (14) qui décale une phase de l'autre signal de sortie en provenance du répartiteur (11) ;
un amplificateur de crête (15) qui amplifie un signal de sortie en provenance du second circuit de filtrage (14) ; et
un combinateur (16) qui combine un signal amplifié en provenance de l'amplificateur de crête (15) et un signal de sortie en provenance du premier circuit de filtrage (13) ;
**caractérisé en ce que**
le premier circuit de filtrage (13) comprend un premier filtre passe-haut (18) qui transmet une composante à plage de fréquence supérieure du signal amplifié en provenance de l'amplificateur de porteuse (12), et un premier filtre passe-bas (19) qui est raccordé en parallèle au premier filtre passe-haut (13), et qui transmet une composante à plage de fréquence inférieure du signal amplifié en provenance de l'amplificateur de porteuse (12) ;
le premier circuit de filtrage (13) transmet une composante à plage toutes fréquences du signal amplifié en provenance de l'amplificateur de porteuse (12) ;
le second circuit de filtrage (14) comprend un second filtre passe-haut (23) qui transmet une composante à plage de fréquence supérieure de l'autre signal de sortie en provenance du répartiteur (11), et un second filtre passe-bas (24) qui est raccordé en parallèle au second filtre passe-haut (23), et qui transmet une composante à plage de fréquence inférieure de l'autre signal de sortie en provenance du répartiteur (11), et
le second circuit de filtrage (14) transmet une composante à plage toutes fréquences de l'autre signal de sortie en provenance du répartiteur (11),
dans lequel le premier circuit de filtrage (13) présente une pluralité d'éléments à paramètres localisés d'une constante d'élément déterminée par une impédance caractéristique d'un côté sortie de l'amplificateur de porteuse (12), une quantité de décalage de phase, et une fréquence de fonctionnement du signal haute fréquence, et dans lequel le second circuit de filtrage (14) présente une pluralité d'éléments à paramètres localisés d'une constante d'élément déterminée par une impédance caractéristique d'un côté entrée de l'amplificateur de crête (15), une quantité de décalage de phase, et une fréquence de fonctionnement du signal haute fréquence.

**2.** Amplificateur Doherty selon la revendication 1, dans lequel le premier circuit de filtrage décale de 90 degrés une phase d'un signal de fréquence de fonctionnement entré dans le premier circuit de filtrage et le second circuit de filtrage décale de 90 degrés une phase d'un signal de fréquence de fonctionnement entré dans le second circuit de filtrage.

FIG. 1

FIG. 2A

TRANSMISSION LOSS (dB)

FIG. 2B

FIG. 2C

FIG. 3A

FIG. 3B

PRIOR ART

FIG. 4

## (a)

FIG. 5A

FIG. 5B

FIG. 6A

FIG. 6B

FIG. 7A

FIG. 7B

FIG. 8

FIG. 9

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- A Novel Doherty Amplifier for Enhanced Load Modulation and Higher Bandwidth. **M. SARKESHI et al.** Microwave Symposium Digest, 2008 IEEE MTT-S International. IEEE, 2008, 763-766